# EUROPÄISCHE PATENTSCHRIFT

(11) **EP 1 010 206 B1**
(45) Veröffentlichungstag und Bekanntmachung des Hinweises auf die Patenterteilung: **01.12.2004**
(21) Anmeldenummer: 98917022.0
(22) Anmeldetag: 19.03.1998
(51) Int. Cl.: H01L 31/0352

(54) **HALBLEITERHETEROSTRUKTUR-STRAHLUNGSDETEKTOR FÜR WELLENLÄNGEN AUS DEM INFRAROTEN SPEKTRALBEREICH**
HETEROSTRUCTURE SEMICONDUCTOR RADIATION DETECTOR FOR WAVELENGTHS FROM THE INFRARED SPECTRAL RANGE
DETECTEUR DE RAYONNEMENT A HETEROSTRUCTURE DE SEMI-CONDUCTEUR POUR LONGUEURS D'ONDE DE LA ZONE SPECTRALE INFRAROUGE

(30) Priorität: 19.03.1997 DE 19711505
(43) Veröffentlichungstag der Anmeldung: 21.06.2000
(73) Patentinhaber: Fraunhofer-Gesellschaft zur Förderung der angewandten Forschung e.V., 80686 München (DE)
(72) Erfinder: SCHNEIDER, Harald, D-79194 Gundelfingen (DE); WALTHER, Martin, D-79285 Ebringen (DE)
(74) Vertreter: Rösler, Uwe, Dipl.-Phys.
(86) Internationale Anmeldenummer: PCT/EP1998/001623
(87) Internationale Veröffentlichungsnummer: WO 1998/042028

(56) Entgegenhaltungen:
- DE-C- 4 220 620
- US-A- 5 165 065
- SCHNEIDER H ET AL: "TRANSPORT ASYMMETRY AND PHOTOVOLTAIC RESPONSE IN (ALGA)AS/ALAS/GAAS/(ALGA)AS SINGLE-BARRIER QUANTUM-WELL INFRARED DETECTORS" APPLIED PHYSICS LETTERS, Bd. 60, Nr. 12, 23. März 1992, Seiten 1471-1473, XP000273288 in der Anmeldung erwähnt
- SIRTORI C ET AL: "Photocurrent reversal induced by localized continuum resonances in asymmetric quantum semiconductor structures" APPLIED PHYSICS LETTERS, 8 NOV. 1993, USA, Bd. 63, Nr. 19, Seiten 2670-2672, XP002073648 ISSN 0003-6951 in der Anmeldung erwähnt
- SCHNEIDER H ET AL: "PHOTOVOLTAIC QUANTUM WELL INFRARED PHOTODETECTORS: THE FOUR-ZONE SCHEME" APPLIED PHYSICS LETTERS, Bd. 71, Nr. 2, 14. Juli 1997, Seiten 246-248, XP000694888

## Beschreibung

### Technisches Gebiet

Die Erfindung bezieht sich auf einen photovoltaischen Halbleiterheterostruktur-Strahlungsdetektor für Wellenlangen aus dem infraroten Spektralbereich, der eine aktive Schicht aufweist, die sich aus einer Vielzahl sich in periodischer Abfolge wiederholenden Einzelschichtsystemen zusammensetzt, die jeweils eine Potentialtopfstruktur mit wenigstens einem Quantumwell mit Subbändern (Quantentopf) vorsehen - die sogenannte Anregungszone -, die einseitig mit einer Tunnelbarrierenzone verbunden ist, deren an die Anregungszone angrenzendes Potential höher ist, als die Bandkantenenergie einer Driftzone, die sich auf der anderen Seite der Potentialtopfstruktur anschließt.

### Stand der Technik

Photodetektoren der vorstehend genannten Gattung sind eine spezielle Sorte von Quantumwell-Intersubband-Photodetektoren, abgekürzt QWIP. Während die üblicherweise vorwendeten QWIP-Strukturen Photoleiter sind, weisen die vorstehend beschriebenen Detektoren photovoltaische Eigenschaften auf, d.h. innerhalb der Detektorstruktur wird bei Belichtung der Detektorstruktur ein Photostrom generiert, ohne daß eine externe elektrische Spannung am Detektor angelegt wird. Derartige photoresistive photovoltaische Eigenschaften aufweisende Detektoren haben den besonderen Vorteil, daß sie im unbeleuchteten Zustand keinem Generations-Rekombinationsrauschen unterliegen, da in ihnen kein Dunkelstrom fließt. Dies ermöglicht insbesondere die Herstellung von Detektoren mit sehr großen Dynamikeigenschaften.

Ein typischer Vertreter eines derartigen Quantentopf-Intersubband-Photodetektors, der für die Detektion von Infrarotwellen optimiert ist, geht aus der DE 42 20 620 Cl hervor. Der darin beschriebene Quantentopf-Intersubband-Infrarot-Photodetektor weist eine Vielzahl von Quantentöpfen auf, die durch breite Barrierenschichten räumlich voneinander getrennt sind. Durch entsprechende Dotierung weist jeder einzelne Quantentopf einen asymmetrischen Potentialverlauf auf, der dazu führt, daß jeweils an beiden Enden der Barrierenschicht Tunnelbarrieren entstehen und sich innerhalb der Barrierenschicht elektronische Zustände bilden. Auf diese Weise wird eine gerichtete Rückrelaxation von in den Barrierenbereich angeregten Ladungsträger ermöglicht, die einen Photostrom bilden, ohne daß eine externe elektrische Spannung an der Schichtenfolge angelegt wird.

In einem Artikel von H. Schneider et al. "Transport asymmetry and photovoltaic response in (AlGa)As/AlAs/GaAs/(AlGa)As single-barrier quantum-well infrared detectors" Appl. Phys. Lett. 60 (12), 23 March 1992, Seite 1471 bis 1473, sind QWIP-Strukturen beschrieben, deren aktive Detektorschicht sich aus einer periodischen Abfolge einer sogenannten Absorptionszone, einer Tunnelbarrierenzone sowie aus einer Driftzone zusammensetzt. Wesentliches Merkmal dieser bekannten Strukturen ist die erhöhte Potentialkante der Tunnelbarrierenzone gegenüber der Driftzone, so daß sich Ladungsträger, die aus der Absorptionszone durch optische Anregung angehoben werden, nicht in Richtung der unmittelbar angrenzenden Tunnelbarrierenzone ausbreiten können, sondern in die entgegengesetzte Richtung über die Driftzone gelangen. Dieser asymmetrische Transportmechanismus setzt sich nach Auffassung der Autoren zum einen aus den asymmetrischen Potentialverläufen sowie aus Streuprozessen an Übergangsbereichen zusammen. Die in Richtung der Driftzone wandernden Ladungsträger gelangen an die Tunnelbarrierenzone der nächsten Schichtabfolge, durch die die Ladungsträger in die Absorptionszone hindurchtunneln.

Aus dem Beitrag von C. Sirtori et al, "Photocurrent reversal induced by localized continuum resonances in asymmetric quantum semiconductor structures", Appl. Phys. Lett. 63, S. 2670 (1993) ist die Verwendung von einer Mehrzahl von Quantum-Well-Strukturen beschrieben, die jeweils mit unterschiedlichen Potentialtopfbreiten ausgebildet sind.

All den vorstehend beschriebenen photovoltaischen Detektoren liegt zwar der Vorteil zugrunde, daß sie gegenüber konventionellen, photoleitenden Detektoren wesentlich geringerem Rauschen unterliegen, da sie aufgrund der fehlenden angelegten externen elektrischen Spannung keinen Dunkelstrom erzeugen, wie bereits vorstehend ausgeführt. Ebenso ist das Johnson-Rauschen aufgrund der sehr großen Impedanz der Detektoren äußerst gering. Da bei den vorliegenden Detektor-Strukturen auch ohne angelegte Spannung ein Photostrom fließt, also eine resistive - nicht nur kapazitive -Kopplung vorliegt, sind mit diesem Detektortyp verbundene Detektor-Arrays sehr gut kompatibel mit Auslese-Elektroniken, wie sie für InSb-bzw. HgCdTe-Detektoren verwendet werden.

Den bekannten photovoltaischen Detektoren haftet jedoch gegenüber konventionellen Detektoren, die mit externer Versorgungsspannung betrieben werden, der Nachteil an, daß sie über eine viel geringere Empfindlichkeit verfügen.

### Darstellung der Erfindung

Den gegenwärtigen Entwicklungsarbeiten liegt daher die Aufgabe zugrunde, gattungsgemäße, auf dem photovoltaischen Prinzip beruhende, Halbleiterhetero-struktur-Strahlungsdetektoren derart weiterzubilden, daß die Detektionsempfindlichkeit verbessert werden soll.

Die Lösung der der Erfindung zugrundeliegenden Aufgabe ist im Anspruch 1 angegeben. Den erfindungsgemäßen Halbleiterheterostruktur-Strahlungsdetektor vorteilhaft weiterbildende Merkmale sind Gegenstand der Ansprüche 2 ff.

Die Erfindung geht von der Weiterentwicklung eines an sich bekannten Halbleiterheterostruktur-Strahlungsdetektors aus, der für die Detektion von Wellenlängen aus dem infraroten Spektralbereich eine aktive Schicht aufweist, die sich aus einer Vielzahl sich in periodischer Abfolge wiederholende Einzelschichtsystemen zusammensetzt. Die Einzelschichtsysteme weisen jeweils eine Potentialstruktur mit wenigstens einem Quantumwell mit Subbändern, den sogenannten Quantentopf auf, der im folgenden als Anregungszone genannt wird. Der Quantentopf ist einseitig mit einer Tunnelbarrierenzone verbunden, deren an die Anregungszone angrenzendes Potential höher ist als die Bandkantenenergie einer Driftzone, die sich auf der anderen Seite der Potentialtopfstruktur anschließt. Ein derartiges Schichtsystem ist, wie bereits vorstehend beschrieben, auch als "Single-Barrierwell"-Struktur bekannt.

Erfindungsgemäß ist die bekannte Struktur dadurch weitergebildet, daß die Driftzone an einer Einfangzone angrenzt, die wenigstens eine, Subbänder enthaltende Quantumwell-Struktur aufweist und mit einer Tunnelbarrierenzone eines in periodischer Abfolge unmittelbar angrenzenden weiteren Einzelschichtsystems verbunden ist. Ferner sind erfindungsgemäß die energetischen Niveaus der Subbänder der Quantumwell-Strukturen innerhalb der Anregungs- und Einfangszone sowie die Dicke der Tunnelbarrierenzone derart dimensioniert, daß eine ausreichende Tunnelwahrscheinlichkeit zum Tunneln von Ladungsträgern von der Einfangzone durch die Tunnelbarrierenzone in die Anregungszone gegeben ist.

### Kurze Beschreibung der Zeichnung

Zur näheren Erläuterung der Erfindung wird auf die nachstehenden Figuren hingewiesen, die Ausführungsbeispiele des erfindungsgemäßen Gedankens zeigen, ohne den allgemeinen Erfindungsgedanken zu beschränken. Es zeigen:
- Fig. 1: Bänderschema eines erfindungsgemäß ausgebildeten Einzelschichtsystems, bestehend aus Anregungs-, Drift-, Einfangs- und Tunnelbarrierenzone,
- Fig. 2a,b: Potentialverlauf und berechnete Wellenfunktionen einer QWIP-Struktur gemäß dem Ausführungsbeispiel der Figur 1 sowie einer QWIP-Struktur mit einer Doppelquantumwell-Struktur in der Einfangszone.

### Darstellung von Ausführungsbeispielen

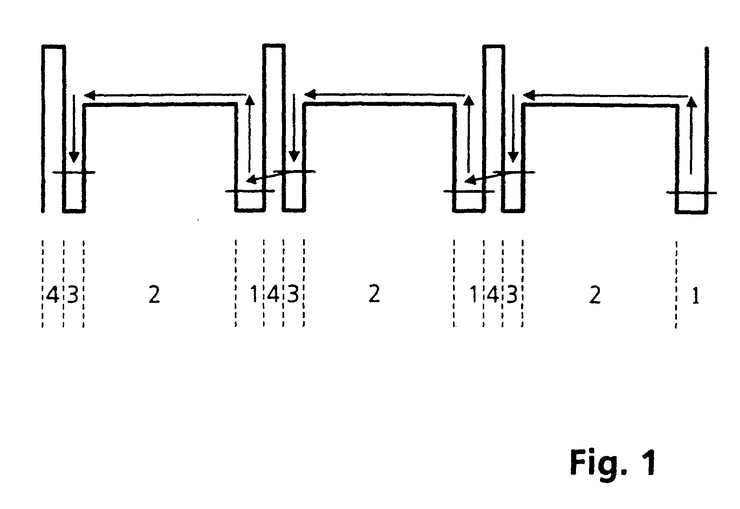

In Fig. 1 ist ein schematischer Potentialverlauf der aktiven Schicht, die ausschnittsweise drei Einzelschichtsysteme in periodischer Abfolge enthält, eines erfindungsgemäß ausgebildeten Halbleiterheterostruktur-Strahlungsdetektors abgebildet. Das Ausführungsbeispiel zeigt die einfachste Schichtanordnung, die aus vier aneinandergrenzenden Einzelzonen besteht.

Im nachfolgenden wird der Ladungsträgertransportmechanismus unter Bezugnahme des in der Fig. 1 dargestellten Ausführungsbeispiels beschrieben.

In der Anregungszone 1, die im vorliegenden Fall aus einem einfachen Quantumwell besteht, werden die in ihm befindlichen Ladungsträger optisch angeregt, wodurch sie in das Quasi-Kontinuum über die Bandkantenenergie der unmittelbar an der Anregungszone 1 angrenzenden Driftzone 2 gehoben werden. Ohne Anlegen einer externen elektrischen Vorspannung wird ein Photostrom generiert, indem die angeregten Ladungsträger über die Driftzone 2 hinweg in die Einfangzone 3 relaxieren. Der Photostrom ist gleichsam wie in den bekannten "Single-Barrierwell"-Strukturen gerichtet, zumal die aus der Anregungszone optisch angeregten Ladungsträger nicht durch die Tunnelbarrierenzone 4 hindurchtunneln können. Gleichwohl ist es jedoch den in der Einfangzone 3 auf entsprechende Subbänder relaxierten Ladungsträger möglich, die Tunnelbarrierenzone 4 zu durchtunneln und den in der benachbarten Anregungszone 1 befindlichen Quantentopf zu besetzen.

Um den gewünschten gerichteten Photostrom zu gewährleisten, ist dafür zu sorgen, daß der Tunnelprozeß genügend schnell abläuft, so daß die in die Einfangzone 3 relaxierten Ladungsträger nicht wieder durch thermische Reemissionsprozesse aus der Einfangzone 3 über die Driftzone 2 in die ursprüngliche Anregungszone 1 gelangen. Zum anderen ist der Potentialverlauf der Tunnelbarrierenzone 4 derart einzurichten, daß die aus der Anregungszone 1 angeregten Ladungsträger nicht unmittelbar durch den Tunnelbarrierenwall in die benachbarte Einfangzone 3 gelangen.

Als besonders vorteilhaft hat sich erwiesen, daß in der Anregungszone 1 eine Ladungsträgerdichte von typischerweise 10¹¹ bis 10¹² Ladungsträger pro Quadratzentimeter vorzusehen sind. Diese Ladungsträgerdichte kann erreicht werden, indem die gesamte Anregungszone 1 oder ein bzw. mehrere Teilbereiche der Anregungszone entsprechend n-dotiert wird bzw. werden. Alternativ oder ergänzend hierzu sind die an die Anregungszone 1 angrenzenden Schichtbereiche ebenso zu dotieren, vorzugsweise im Wege einer Modulationsdotierung. Während die nachstehenden Ausführungen sich auf eine n-Dotierung der Anregungszone konzentriert und daher der Prozeß der Photoabsorption sich auf die Anregung von Elektronen beschränkt, ist ebensogut eine p-Dotierung der Anregungszone sowie der angrenzenden Zonen möglich, wodurch der Detektionsprozeß über die Anregung von Löchern erfolgen würde.

Außer im Falle einer Modulationsdotierung in den an die Anregungszone 1 angrenzenden Schichtbereiche sind die Drift-Einfangzone und/oder die Tunnelbarrierenzone vorzugsweise undotiert zu belassen.

Unter Zugrundelegung der in Fig. 1 dargestellten Einzelschichtsystem-Strukturen ist ein erfindungsgemäßer Strahlungsdetektor nach den nachstehenden Angaben gefertigt worden: Die aktive Schicht des Strahlungsdetektors besteht aus 20 sich in periodischer Abfolge wiederholenden Einzelschichtsystemen, die mit Hilfe von an sich bekannten Epitaxiverfahren herzustellen sind. Die Einfangzone 3 bildet eine 3,6 nm dicke Ga/As-Schicht, die an einer 45 nm-dicken Driftzone angrenzt, die aus Al_{0 , 2 4}Ga_{0 , 7 6}As zusammengesetzt ist. Die an die Driftzone 2 angrenzende Anregungszone besteht aus einer 4,8 nm-dicken GaAs-Schicht. Die Tunnelbarrierenzone weist hingegen eine Schichtenfolge aus 3,6 nm Al_{0 , 2 4}Ga_{0 ,7 6}As, 0,6 nm AlAs, 1,8 nm Al_{0 , 2 4}Ga_{0 , 7 6}As sowie 0,6 nm AlAs auf.

Die aus einer 4,8 nm dicken GaAs-Schicht bestehende Einfangzone ist mit einer Ladungsträgerflächenkonzentration von 4 x 10¹¹ cm⁻² n-dotiert. Die aus den einzelnen Schichtsystemen zusammengesetzte aktive Schicht des Detektors ist gleichsam einer Sandwich-Struktur zwischen zwei aus Silizium-dotiereten GaAs bestehenden Kontaktschichten mit einem n-Dotierungsgehalt von 1,0 x 10¹⁸ cm⁻³ eingeschlossen.

Neben dem vorstehend beschriebenen Ausführungsbeispiel mit dem Materialsystem GaAs/AlGaAs sind jedoch auch Schichtsysteme mit anderen Materiallsystemen denkbar, wie beispielsweise InGaAs/GaAs, InGaAs/AlGaAs sowie InGaAs/InAlAs/InP.

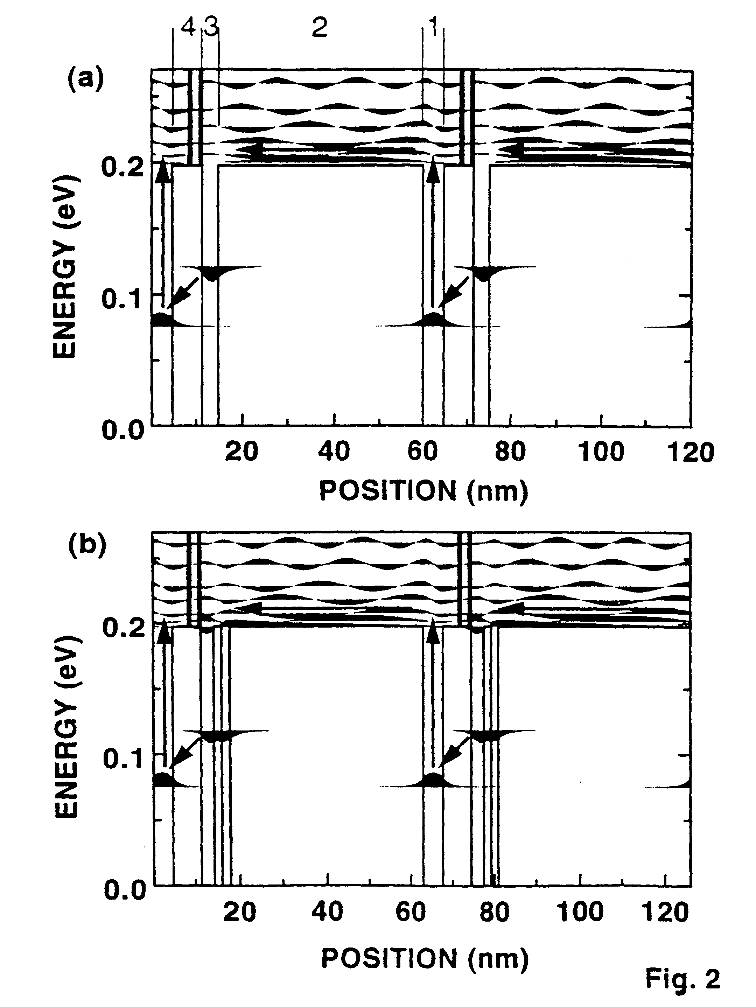

Unter Bezugnahme auf das vorstehend beschriebene Ausführungsbeispiel eines erfindungsgemäßen Halbleiterheterostruktur-Strahlungsdetektors wird auf Fig. 2a verwiesen, in der zum einen der Potentialverlauf der Einzelschichtsysteme dargestellt ist, sowie der Verlauf berechneter Wellenfunktionen der Ladungsträger.

Aus der Fig. 2a ist zu entnehmen, daß die Tunnelbarrierenzone 4 zwei erhöhte Potentialpeaks aufweist, die jeweils von den vorstehend beschriebenen AlAs-Schichten herrühren. Diese beiden Potentialpeaks dienen dazu, die Tunnelwahrscheinlichkeit für Ladungsträger, die durch optische Anregung aus der Anregungszone 1 in das freie Energiekontinuum angehoben worden sind und möglicherweise via Tunnelprozeß durch die Tunnelbarrierenzone 4 hindurchgelangen, erheblich zu reduzieren. Auf diese Weise gelangen die angeregten Ladungsträger gerichtet über die Driftzone 2 entsprechend zur Einfangzone 3. Ferner ist es von Vorteil in der Einfangzone mindestens ein Subband so tief wie möglich innerhalb der Quantumwellstruktur einzurichten, so daß auf dieses Subband, wovon in der Fig. 2a lediglich ein Representant der Subbänder mit der entsprechenden Wellenfunktion eingezeichnet ist, relaxierte Ladungsträger nicht durch thermische Anregung aus dem entsprechenden Potentialtopf wieder angehoben werden können. Ferner ist darauf zu achten, daß sich die energetische Lage dieser tiefen Subbänder oberhalb des Grundzustands des Potentialtopfes der Anregungszone befindet. Ein Durchtunneln der Tunnelbarrierenzone 1 erfolgt sodann auf, in der Anregungszone 1 energetisch tiefergelegene Subbänder, wie es der Fig. 2a durch die Pfeilabfolge zu entnehmen ist.

Um zu vermeiden, daß die aus der Anregungszone 1 angeregten Ladungsträger nach Durchlaufen der Driftzone 2 an der Tunnelbarrierenzone 4 ohne in die Einfangzone 3 zu relaxieren, quasi reflektiert werden und in Gegenrichtung zur ursprünglichen Anregungszone 1, d.h. gegen den Photostrom, zurücklaufen, ist die Quantumwell-Struktur der Einfangzone 3 derart vorzusehen, daß wenigstens ein Subband oder eine Kontinuums-Resonanz bei Energien in der Nähe der Bandkantenenergie der Driftzone 2 vorgesehen ist, so daß die Aufenthaltswahrscheinlichkeit von Ladungsträgern mit diesen Energien im Bereich der Einfangzone 3 maximiert wird. Ergänzend oder alternativ zur vorstehenden Dimensionierung derartiger Subbänder können darüberhinaus auch Subbänder den Einfangprozeß von Ladungsträgern in der Einfangzone 1 optimieren, sofern Subbänder im Bereich einer optischen Phononenenergie unterhalb der Bandkantenenergie der Driftzone 2 im Potentialtopf der Einfangzone vorgesehen sind.

Um die Detektionsempfindlichkeit zu maximieren, ist die Schichtdicke der Quantumwellstruktur innerhalb der Anregungszone 1 derart zu bemessen, daß wenigstens ein Subband oder eine Kontinuums-Resonanz bei Energien in der Nähe der Bandkantenenergie der Driftzone 2 vorliegt, so daß die Oszillatorstärke für optische Übergänge in freie Endzustände maximiert wird.

Neben der Möglichkeit, die Anregungs- und Einfangzone aus nur einem einzigen Potentialtopf zu bilden, können diese Zonen vorzugsweise auch durch Doppel-, Mehrfach-Quantumwellstrukturen oder als Übergitter ausgebildet werden.

In Fig. 2b ist der Potentialverlauf sowie berechnete Wellenfunktionen einer erfindungsgemäßen photovoltaischen QWIP-Struktur dargestellt, bei der innerhalb der Einfangzone jeweils eine Doppelquantumwell-Struktur vorgesehen ist. Die doppelte Abfolge zweier eng miteinander gekoppelter Potentialtöpfe innerhalb der Einfangzone 3 führt nicht zuletzt aufgrund ihrer vergrößerten Breite zu einer erhöhten Einfangwahrscheinlichkeit. Aus Fig. 2b ist im Unterschied zu der Fig. 2a zu sehen, daß innerhalb der Einfangzone in der Nähe der Bandkante der Driftzone 2 eine erhöhte Zustandsdichte der Wellenfunktion vorliegt, wodurch auch die Einfangwahrscheinlichkeit in dieser Zone erhöht ist. In dem in Fig. 2b dargestellten Ausführungsbeispiel handelt es sich in der Einfangzone 3 um eine Doppelquantumwell-Struktur bestehend aus GaAs-Al_{0 , 2 4}Ga_{0 , 7 6} As-GaAs. Die Tunnelbarrierenzone 4 besteht aus einer Al_{0 , 2 4}Ga_{0 , 7 6}As-AlAs-Al_{0 , 2 4}Ga_{0 , 7 6}As-AlAs Heterostruktur.

Durch eine derartige Strukturierung der einzelnen Zonen lassen sich Detektivität, Detektionswellenlängen, spektraler Verlauf, Responsitivität sowie das Zeitverhalten, um nur einige Eigenschaften des Detektors zu nennen, gezielt beeinflussen.

Die aktive Schicht des erfindungsgemäßen Heterostrukturhalbleiter-Strahlungsdetektors besteht typischerweise aus 1 bis 100 periodischen Abfolgen der erfindungsgemäßen Einzelschicht und weist oberhalb und unterhalb der Schichtstruktur zur elektrischen Kontaktierung entsprechend dotierte Schichten auf. Besonders bevorzugt ist es, daß an den Rändern der aktiven Schicht zusätzliche Tunnelbarrierenzonen eingefügt sind, um die Linearität der Detektoren zu verbessern.

Mit dem vorstehend dargestellten erfindungsgemäßen Aufbau eines Halbleiterheterostruktur-Strahlungsdetektors konnte gezeigt werden, daß die Responsitivität, d.h. das Ansprechverhalten, durch die Optimierung der Einfangzone nachhaltig verbessert wird.

So wurde bei der in Figur 2 b dargestellten Detektorstruktur ein dreimal so hohe Responsivität beobachtet wie bei der Struktur von Figur 2a.

Dies wurde insbesondere durch die Verwendung einer Doppelquantumwell-Struktur in der Einfangzone erreicht. Dadurch ergab sich außerdem eine sehr hohe Detektivität welche einen ähnlichen Wert aufweist wie diejenige einer konventionellen, photoleitenden QWIP-Struktur.

Durch die besondere Rauscharmheit der Detektoren sind die erfindungsgemäß ausgebildeten photovoltaischen Detektoren für sogenannte Focal-Plane-Array Kamerasysteme von besonderem Interesse, zumal sie keinen Dunkelstrom aufweisen und eine erhöhte Detektivität bei kleinen Photoströmen erreichen. Beide Eigenschaften führen gegenüber konventionellen, photoleitenden Quantenwell-Intersubband-Photodetektoren zu stark reduzierten Strompegeln und damit zu einer großen maximalen Integrationszeit und zu einer verringerten Kühlleistung. Ebenso finden derartige Detektoren Einsatz in ungekühlten Monitordetektoren für Fern-Infrarotlaser.

## Patentansprüche

1. Photovoltaischer Halbleiterheterostruktur-Strahlungsdetektor für Wellenlängen aus dem infraroten Spektralbereich, der eine aktive Schicht aufweist, die sich aus einer Vielzahl sich in periodischer Abfolge wiederholenden Einzelschichtsystemen zusammensetzt, die jeweils eine Potentialtopfstruktur mit wenigstens einem Quantumwell mit Subbändern als Anregungszone (1) vorsieht, die einseitig mit einer Tunnelbarrierenzone (4) verbunden ist, deren an die Anregungszone angrenzendes Potential höher ist, als die Bandkantenenergie einer Driftzone (2), die sich auf der anderen Seite der Potentialtopfstruktur anschließt,
**dadurch gekennzeichnet, daß** die Driftzone (2) an einer Einfangzone (3) angrenzt, die wenigstens eine, Subbänder enthaltende Quantumwell-Struktur aufweist und mit der Tunnelbarrierenzone (4) eines in periodischer Abfolge unmittelbar angrenzenden weiteren Einzelschichtsystems bestehend aus Anregungszone (1), Driftzone (2), Einfangszone (3) und Tunnelbarrierenzone (4) verbunden ist,
daß die energetischen Niveaus der Subbänder der Quantumwell-Strukturen innerhalb der Anregungs- und Einfangzone sowie die Dicke der Tunnelbarrierenzone derart eingestellt sind, daß eine ausreichende Tunnelwahrscheinlichkeit zum Tunneln von Ladungsträgern von der Einfangzone (3) durch die Tunnelbarrierenzone (4) in die Anregungszone (1), vorhanden ist.

2. Halbleiterheterostruktur-Strahlungsdetektor nach Anspruch 1,
**dadurch gekennzeichnet, daß** die Anregungszone Ladungsträger enthält mit einer Flächenkonzentration von typischerweise 10¹¹ bis 10¹² pro cm².

3. Halbleiterheterostruktur-Strahlungsdetektor nach Anspruch 2,
**dadurch gekennzeichnet, daß** die Anregungszone oder eines bzw. mehrere ihrer Teilbereiche n- oder p-dotiert sind.

4. Halbleiterheterostruktur-Strahlungsdetektor nach einem der Ansprüche 1 bis 3,
**dadurch gekennzeichnet, daß** die Drift-, Einfangzone und/oder die Tunnelbarrierenzone undotiert sind.

5. Halbleiterheterostruktur-Strahlungsdetektor nach einem der Ansprüche 1 bis 3,
**dadurch gekennzeichnet, daß** die Drift-, Einfangzone und/oder die Tunnelbarrierenzone eine schwache Modulationsdotierung aufweist.

6. Halbleiterheterostruktur-Strahlungsdetektor nach einem der Ansprüche 1 bis 5,
**dadurch gekennzeichnet, daß** die Einfangzone als Doppel-, Mehrfach-Quantumwellstruktur oder als Übergitter ausgebildet ist.

7. Halbleiterheterostruktur-Strahlungsdetektor nach Anspruch 6,
**dadurch gekennzeichnet, daß** die Schichtdicken der einzelnen Quantumwellstrukturen derart bemessen sind, daß die Quantumwells wenigstens ein Subband oder eine Kontinuumsresonanz bei Energien in der Nähe der Bandkantenenergie der Driftzone aufweisen, so daß die Aufenthaltswahrscheinlichkeit von Ladungsträgern mit diesen Energien im Bereich der Einfangzone maximiert wird.

8. Halbleiterheterostruktur-Strahlungsdetektor nach Anspruch 6 oder 7,
**dadurch gekennzeichnet, daß** die Schichtdicken der einzelnen Quantumwellstrukturen derart bemessen sind, daß die Quantumwells wenigstens ein Subband im Bereich einer optischen Phononenenergie unterhalb der Bandkantenenergie der Driftzone aufweisen.

9. Halbleiterheterostruktur-Strahlungsdetektor nach einem der Ansprüche 1 bis 8,
**dadurch gekennzeichnet, daß** die Anregungszone als Doppel-, Mehrfach-Quantumwellstruktur oder als Übergitter ausgebildet ist.

10. Halbleiterheterostruktur-Strahlungsdetektor nach Anspruch 9,
**dadurch gekennzeichnet, daß** die Schichtdicken der einzelnen Quantumwellstrukturen derart bemessen sind, daß die Quantumwells wenigstens ein Subband oder eine Kontinuumsresonanz bei Energien in der Nähe der Bandkantenenergie der Driftzone aufweisen, so daß die Oszillatorstärke für optische Übergänge in Endzustände mit diesen Energien maximiert wird.

11. Halbleiterheterostruktur-Strahlungsdetektor nach einem der Ansprüche 1 bis 10,
**dadurch gekennzeichnet, daß** die Tunnelbarrierenzone aus einer homogenen Einzelschicht besteht.

12. Halbleiterheterostruktur-Strahlungsdetektor nach einem der Ansprüche 1 bis 10,
**dadurch gekennzeichnet, daß** die Tunnelbarrierenzone als kurzperiodisches Übergitter ausgeführt ist, dessen Bandkante höher liegt als die Bandkante der Driftzone.

13. Halbleiterheterostruktur-Strahlungsdetektor nach einem der Ansprüche 1 bis 10 oder 12,
**dadurch gekennzeichnet, daß** die Tunnelbarrierenzone aus mehreren Einzelschichten unterschiedlicher Material-zusammensetzung besteht.

14. Halbleiterheterostruktur-Strahlungsdetektor nach einem der Ansprüche 1 bis 13,
**dadurch gekennzeichnet, daß** die Tunnelbarrierenzone eine Gesamtdicke aufweist, die
- dünn genug ist, um das Tunneln vom untersten Subband der Einfangzone zum untersten Subband der Anregungszone zu ermöglichen,
- dick genug ist, so daß diese Subbänder genügend stark in der Einfangzone bzw. Anregungszone lokalisiert sind und keine Hybridzustände ausbilden, und
- dick genug ist, um die Tunnelwahrscheinlichkeit im Bereich der Energien oberhalb der Bandkante der Tunnelbarrierenzone deutlich zu reduzieren, um die Emissionswahrscheinlichkeit in Richtung Driftzone zu erhöhen.

15. Halbleiterheterostruktur-Strahlungsdetektor nach einem der Ansprüche 1 bis 14,
**dadurch gekennzeichnet, daß** die Driftzone als kurzperiodisches Übergitter ausgeführt ist, dessen Bandkante niedriger liegt als die Bandkante der Tunnelbarrierenzone.

16. Halbleiterheterostruktur-Strahlungsdetektor nach einem der Ansprüche 1 bis 14,
**dadurch gekennzeichnet, daß** die Driftzone oder deren Teilbereiche dotiert sind, so daß sich aufgrund der Relaxation der durch die Dotierung eingebrachten Ladungsträger ein internes elektrisches Feld ausbildet, das sich dem Bandkantenverlauf überlagert.

17. Halbleiterheterostruktur-Strahlungsdetektor nach einem der Ansprüche 1 bis 14,
**dadurch gekennzeichnet, daß** die Driftzone eine Schichtdikke von typischerweise 40 bis 100nm aufweist, so daß der Tunnelstrom durch die Driftzone unterdrückt wird.

18. Halbleiterheterostruktur-Strahlungsdetektor nach einem der Ansprüche 1 bis 17,
**dadurch gekennzeichnet, daß** die Anregungs- und Einfangzone als GaAs-Quantumwells ausgebildet sind, wobei das unterste Subband der Anregungszone bei einer niedrigeren Energie liegt als das unterste Subband der Einfangzone, und die Drift- und Tunnelbarrierenzone aus AlGaAs-Schichten unterschiedlichen Al-Gehalts ausgebildet sind, wobei der Al-Gehalt der Driftzone niedriger ist als der Al-Gehalt der Tunnelbarrirenzone.

19. Halbleiterheterostruktur-Strahlungsdetektor nach einem der Ansprüche 1 bis 17,
**dadurch gekennzeichnet, daß** die Einzelschichtsysteme der aktiven Schicht aus GaAs-, AlAs- sowie AlGaAs-Einzelschichten bestehen, wobei die Anregungszone aus einer GaAs/AlGaAs Einfach- oder Mehrfach-Quantumwellstruktur, die Driftzone aus einer homogenen AlGaAs-Schicht oder einem GaAs/AlGaAs Übergitter, die Einfangzone aus einem GaAs/AlGaAs Einfach- oder Mehrfach-Quantumwell, sowie die Tunnelbarrierenzone aus einer homogenen AlGaAs-Schicht, oder aus AlGaAs und AlAs-Einzelschichten besteht.

20. Halbleiterheterostruktur-Strahlungsdetektor nach einem der Ansprüche 1 bis 17,
**dadurch gekennzeichnet, daß** die Einzelschichtsysteme aus GaAs, AlGaAs sowie pseudomorph verspannten InGaAs-Einzelschichten bestehen, wobei die Anregungszone aus einer InGaAs oder einer GaAs/InGaAs/AlGaAs Einfach- oder Mehrfach-Quantumwellstruktur, die Driftzone aus einer homogenen GaAs-Schicht, die Einfangzone aus einem GaAs/InGaAs/AlGaAs Einfach- oder Mehrfach-Quantumwell, sowie die Tunnelbarrierenzone aus einer homogenen AlGaAs-Schicht oder aus AlGaAs und AlAs-Einzelschichten besteht.

21. Halbleiterheterostruktur-Strahlungsdetektor nach einem der Ansprüche 1 bis 17,
**dadurch gekennzeichnet, daß** die Einzelschichtsysteme aus InGaAs, InAlAs und/oder quarternären InAlGaAs-Legierungen, welche an die Gitterkonstante eines InP-Substrates gitterangepaßt sind, und/oder aus InP-Schichten bestehen, wobei die Anregungszone aus einer InGaAs Einfach- oder Mehrfachquantumwellstruktur, die Driftzone aus einer homogenen InAlGaAs- oder InP-Schicht, die Einfangzone aus einem InGaAs-Einfach-oder Mehrfachquantumwellstruktur, sowie die Tunnelbarrierenzone aus einer homogenen InAlAs-, InP-oder InAlGaAs oder aus mehreren derartigen Einzelschichten besteht.

22. Halbleiterheterostruktur-Strahlungsdetektor nach einem der Ansprüche 1 bis 17,
**dadurch gekennzeichnet, daß** die Einzelschichtsysteme aus SiGe-Legierungs-Schichten bestehen, wobei die Variation des Potentialverlaufs durch die unter-schiedlichen Legierungskompositionen erzielbar ist.

23. Halbleiterheterostruktur-Strahlungsdetektor nach einem der Ansprüche 1 bis 22,
**dadurch gekennzeichnet, daß** die Einzelschichtsysteme epitaktisch auf einem Substratwafer abgeschieden sind, so daß die Schichten parallel zur Schichtoberfläche liegen, und daß oberhalb und unterhalb der Schichten n- bzw. p-dotierte Schichten zur elektrischen Kontaktierung vorgesehen sind.

24. Halbleiterheterostruktur-Strahlungsdetektor nach einem der Ansprüche 1 bis 23,
**dadurch gekennzeichnet, daß** Tunnelbarrierenschichten an den Rändern der aktiven Schicht vorgesehen sind.

## Claims

1. A photovoltaic semiconductor heterostructure radiation detector for wavelengths in the infrared spectral range provided with an active layer composed of a multiplicity of periodically recurring single-layer systems each provided with a potential well structure having at least one quantum well with subbands as the excitation zone (1) which is connected on one side to a tunnel barrier zone (4) whose potential adjacent to said excitation zone is higher than the band edge energy of a drift zone (2) adjacent on the other side of said potential-well structure,
wherein said drift zone (2) is adjacent to a trap zone (3) which is provided with at least one quantum-well structure containing subbands and is connected to the tunnel barrier zone (4) of another single-layer system immediately adjacent in periodic sequence comprising an excitation zone (1), a drift zone (2), trap zone (3) and a tunnel barrier zone (4) and
wherein the energy levels of said subbands of said quantum-well structures inside said excitation zone and said trap zone as well as the thickness of said tunnel barrier zone are set in such a manner that there is sufficient tunneling probability for the charge carriers to tunnel from the trap zone (3) through the tunnel barrier zone (4) into the excitation zone (1).

2. A semiconductor heterostructure radiation detector according to claim 1,
**wherein** said excitation zone contains charge carriers having an areal concentration of typically 10¹¹ to 10¹² per cm².

3. A semiconductor heterostructure radiation detector according to claim 2,
wherein said excitation zone or one respectively several sections of said excitation zone are n-doped or p-doped.

4. A semiconductor heterostructure radiation detector according to one of the claims 1 to 3,
**wherein** said drift zone, trap zone and/or tunnel barrier zone are undoped.

5. A semiconductor heterostructure radiation detector according to one of the claims 1 to 3,
**wherein** said drift zone, trap zone and/or tunnel barrier zone are provided with a weak modulation doping.

6. A semiconductor heterostructure radiation detector according to one of the claims 1 to 5,
wherein said trap zone is provided as a double or multiple quantum-well structure or as a superlattice.

7. A semiconductor heterostructure radiation detector according to claim 6,
wherein the layer thickness of said individual quantum-well structures are dimensioned in such a manner that said quantum wells have at least one subband or a continuum resonance at energies in the vicinity of the band-edge energy of said drift zone so that the occurrence probability of said charge carriers having said energies is maximized in the region of said trap zone.

8. A semiconductor heterostructure radiation detector according to claim 6 or 7,
wherein the layer thickness of said single quantum-well structures are dimensioned in such a manner that said quantum wells have at least one subband in the range of an optical phonon energy below said band-edge energy of said drift zone.

9. A semiconductor heterostructure radiation detector according to one of the claims 1 to 8,
**wherein** said excitation zone is provided as a double or multiple quantum-well structure or as a superlattice.

10. A semiconductor heterostructure radiation detector according to claim 9,
wherein the layer thickness of said single quantum-well structures are dimensioned in such a manner that said quantum wells have at least one subband or a continuum resonance at energies in the vicinity of said band-edge energies of said drift zone in such a manner that the oscillator power is maximized for optical transitions into end states having these energies.

11. A semiconductor heterostructure radiation detector according to one of the claims 1 to 10,
wherein said tunnel barrier zone is composed of a homogeneous single layer.

12. A semiconductor heterostructure radiation detector according to one of the claims 1 to 10,
wherein said tunnel barrier zone is executed as a short periodic superlattice whose band edge lies higher than the band edge of said drift zone.

13. A semiconductor heterostructure radiation detector according to one of the claims 1 to 10 or 12,
**wherein** said tunnel barrier zone is composed of several single layers of different material compositions.

14. A semiconductor heterostructure radiation detector according to one of the claims 1 to 13,
wherein said tunnel barrier zone has an overall thickness which
• is thin enough to permit tunneling from the bottom subband of said trap zone to the bottom subband of said excitation zone,
• is thick enough that said subbands are localized strongly enough in said trap zone respectively in said excitation zone and do not develop hybrid states, and
• is thick enough to distinctly reduce tunneling probability in the range of the energies above the band edge of said tunnel barrier zone in order to raise emission probability in the direction of said drift zone.

15. A semiconductor heterostructure radiation detector according to one of the claims 1 to 14,
wherein said drift zone is provided as a short periodic superlattice whose band edge lies lower than the band edge of said tunnel barrier zone.

16. A semiconductor heterostructure radiation detector according to one of the claims 1 to 14,
**wherein** said drift zone or sections thereof are doped in such a manner that an internal electric field, which overlaps the course of the band edge, develops due to the relaxation of the charge carriers inserted by said doping.

17. A semiconductor heterostructure radiation detector according to one of the claims 1 to 14,
**wherein** said drift zone has a layer thickness of typically 40 to 100 nm so that the tunnel current through said drift zone is suppressed.

18. A semiconductor heterostructure radiation detector according to one of the claims 1 to 17,
wherein said excitation zone and said trap zone are provided as GaAs quantum-well structures with the bottom subband of said excitation zone lying at a lower energy than the bottom subband of said trap zone and said drift zone and tunnel barrier zone are provided from AlGaAs layers of different Al content with the Al content of said drift zone being lower than the Al content of said tunnel barrier zone.

19. A semiconductor heterostructure radiation detector according to one of the claims 1 to 17,
**wherein** said single-layer systems of said active layer are composed of GaAs-, AlAs- and AlGaAs single layers, with said excitation zone being composed of a GasAs/AlGaAs single or multiple quantum-well structure, said drift zone being compsoed of a homogeneous AlGaAs layer or a GaAs/AlGaAs superlattice, said trap zone being composed of a GaAs/AlGaAs single or multiple quantum well and said tunnel barrrier zone being composed of a homogeneous AlGaAs layer or of AlGaAs and AlAs single layers.

20. A semiconductor heterostructure radiation detector according to one of the claims 1 to 17,
**wherein** said single-layer systems are composed of GaAs, AlGaAs and pseudomorphously warped InGaAs single layers with said excitation zone being composed of an InGaAs or a GaAs/InGaAs/AlGaAs single or multiple quantum-well structure, said drift zone being composed of a homogeneous GaAs layer, said trap zone being composed of a GaAs/InGaAs/AlGaAs single or multiple quantum-well and said tunnel barrier zone being composed of a homogeneous AlGaAs layer or AlGaAs and AlAs single layers.

21. A semiconductor heterostructure radiation detector according to one of the claims 1 to 17,
**wherein** said single-layer systems are composed of InGaAs, InAlAs and/or quarternary InAlGaAs alloys, which are lattice-adapted to the lattice constants of an InP substrate, and/or are composed of InP layers, with said excitation zone being composed of an InGaAs simple or multiple quantum-well structure, said drift zone of a homogeneous InAlGaAs or InP, said trap zone being composed of an InGaAs simple or multiple quantum-well structure, and said tunnel barrier zone composed of a homogeneous InAlAs, InP or InAlGaAs layer or of several such single layers.

22. A semiconductor heterostructure radiation detector according to one of the claims 1 to 17,
**wherein** said single-layer systems are composed of SiGe alloy layers with the variation of the potential course being obtained by different alloy compositions.

23. A semiconductor heterostructure radiation detector according to one of the claims 1 to 22,
wherein said single-layer systems are precipitated on a substrate wafer in such a manner that said layers lie parallel to the layer surface and that above and below said layers, n-doped respectively p-doped layers are provided for electric contacting.

24. A semiconductor heterostructure radiation detector according to one of the claims 1 to 23,
**wherein** said tunnel barrier layers are provided at the edges of said active layer.

## Revendications

1. Détecteur photovoltaïque de rayonnement à hétérostructure semiconductrice pour des longueurs d'ondes du domaine spectral infrarouge, lequel présente une couche active qui se compose d'une pluralité de systèmes de couches individuelles récurrents à intervalles périodiques, des systèmes qui prévoient chacun une structure de puit de potentiel avec au moins un puit quantique avec des sous-bandes pour former la zone d'excitation (1) qui est reliée d'un côté à une zone barrière à effet tunnel (4) dont le potentiel contigu à la zone d'excitation est plus élevé que l'énergie de limite de bande d'une zone de dérive (2) qui vient se raccorder de l'autre côté de la structure de puits de potentiel,
**caractérisé en ce que** la zone de dérive (2) est adjacente à une zone de capture (3) qui présente au moins une structure de puit quantique avec sous-bandes et est reliée avec une zone barrière à effet tunnel (4) d'un autre système de couches individuelles directement voisin selon une succession périodique, lequel se compose d'une zone d'excitation (1), d'une zone de dérive (2), d'une zone de capture (3) et d'une zone barrière à effet tunnel (4),
et **en ce que** les niveaux énergétiques des sous-bandes des structures de puit quantique à l'intérieur des zones d'excitation et de capture ainsi que l'épaisseur de la zone barrière à effet tunnel sont dimensionnés de façon à garantir une probabilité suffisante d'effet tunnel pour transporter par effet tunnel des porteurs de charge de la zone de capture (3) dans la zone d'excitation (1) en traversant la zone barrière à effet tunnel (4).

2. Détecteur de rayonnement à hétérostructure semiconductrice selon fa revendication 1,
**caractérisé en ce que** la zone d'excitation contient des porteurs de charge présentant une densité typique comprise entre 10¹¹ et 10¹² porteurs par cm².

3. Détecteur de rayonnement à hétérostructure semiconductrice selon la revendication 2,
**caractérisé en ce que** la zone d'excitation ou une ou plusieurs de ses sections ont subi un dopage de type n ou p.

4. Détecteur de rayonnement à hétérostructure semiconductrice selon l'une des revendications 1 à 3,
**caractérisé en ce que** les zones de dérive, de capture et/ou la zone barrière à effet tunnel ne sont pas dopées.

5. Détecteur de rayonnement à hétérostructure semiconductrice selon l'une des revendications 1 à 3,
**caractérisé en ce que** les zones de dérive, de capture et/ou la zone barrière à effet tunnel présente un léger dopage sélectif.

6. Détecteur de rayonnement à hétérostructure semiconductrice selon l'une des revendications 1 à 5,
**caractérisé en ce que** la zone de capture est configurée en structure à deux ou plusieurs puits quantiques ou en superstructure.

7. Détecteur de rayonnement à hétérostructure semiconductrice selon la revendication 6,
**caractérisé en ce que** l'épaisseur des couches de chaque structure à puit quantique est calculée de telle sorte que les puits quantiques présentent au moins une sous-bande ou une résonance de continuum pour des énergies proches de l'énergie de limite de bande de la zone de dérive de façon à maximiser la probabilité de séjour des porteurs présentant ces énergies aux alentours de la zone de capture.

8. Détecteur de rayonnement à hétérostructure semiconductrice selon la revendication 6 ou 7,
**caractérisé en ce que** l'épaisseur des couches de chaque structure à puit quantique est calculée de telle sorte que les puits quantiques présentent au moins une sous-bande dans une plage d'énergie photonique optique inférieure à l'énergie de limite de bande de la zone de dérive.

9. Détecteur de rayonnement à hétérostructure semiconductrice selon l'une des revendications 1 à 8,
**caractérisé en ce que** la zone d'excitation est configurée en structure à deux ou plusieurs puits quantiques ou en superstructure.

10. Détecteur de rayonnement à hétérostructure semiconductrice selon la revendication 9,
**caractérisé en ce que** l'épaisseur des couches de chaque structure à puit quantique est calculée de telle sorte que les puits quantiques présentent au moins une sous-bande ou une résonance de continuum pour des énergies proches de l'énergie de limite de bande de la zone de dérive de façon à maximiser la puissance de l'oscillateur pour des transitions optiques dans des états finaux avec ces énergies.

11. Détecteur de rayonnement à hétérostructure semiconductrice selon l'une des revendications 1 à 10,
**caractérisé en ce que** la zone barrière à effet tunnel se compose d'une couche unique homogène.

12. Détecteur de rayonnement à hétérostructure semiconductrice selon l'une des revendications 1 à 10,
**caractérisé en ce que** la zone barrière à effet tunnel est configurée comme une superstructure à période courte dont la limite de bande est supérieure à celle de la zone de dérive.

13. Détecteur de rayonnement à hétérostructure semiconductrice selon l'une des revendications 1 à 10 ou 12,
**caractérisé en ce que** la zone barrière à effet tunnel est constituée de plusieurs couches individuelles composées avec différents matériaux.

14. Détecteur de rayonnement à hétérostructure semiconductrice selon l'une des revendications 1 à 13,
**caractérisé en ce que** la zone barrière à effet tunnel présente une épaisseur totale, qui est
- suffisamment mince pour permettre le passage sous effet tunnel de la sous-bande inférieure de la zone de capture vers la sous-bande inférieure de la zone d'excitation,
- suffisamment épaisse de manière que ces sous-bandes soient localisées de façon suffisamment dense dans la zone de capture ou la zone d'excitation et ne forment pas d'états hybrides, et
- suffisamment épaisse pour réduire considérablement la probabilité d'effet tunnel dans la région des énergies au dessus de la limite de bande de la zone barrière à effet tunnel de façon à augmenter les probabilités d'émission en direction de la zone de dérive.

15. Détecteur de rayonnement à hétérostructure semiconductrice selon l'une des revendications 1 à 14,
**caractérisé en ce que** la zone de dérive est configurée en superstructure à période courte dont la limite de bande est inférieure à celle de la zone barrière à effet tunnel.

16. Détecteur de rayonnement à hétérostructure semiconductrice selon l'une des revendications 1 à 14,
**caractérisé en ce que** la zone de dérive ou ses sections partielles sont dopées de sorte qu'en raison de la relaxation des porteurs introduits par le dopage se forme un champ électrique interne qui se superpose aux limites de bande.

17. Détecteur de rayonnement à hétérostructure semiconductrice selon l'une des revendications 1 à 14,
**caractérisé en ce que** la zone de dérive présente une épaisseur de couche typique comprise entre 40 et 100 nm de manière à atténuer le courant d'effet tunnel.

18. Détecteur de rayonnement à hétérostructure semiconductrice selon l'une des revendications 1 à 17,
**caractérisé en ce que** les zones d'excitation et de capture sont configurées comme des puits quantiques GaAs, la sous-bande inférieure de la zone d'excitation étant située à une énergie plus basse que la sous-bande inférieure de la zone de capture, et les zones de dérive et barrière à effet tunnel sont configurées en couches AlGaAs de teneur différente en Al, la teneur en Al de la zone de dérive étant inférieure à celle de la zone barrière à effet tunnel.

19. Détecteur de rayonnement à hétérostructure semiconductrice selon l'une des revendications 1 à 17,
**caractérisé en ce que** les systèmes de couches individuelles de la couche active se composent de couches individuelles GaAS, AlAs et AlGaAs, la zone d'excitation se composant d'une structure à puit quantique simple ou multiple GaAs/AlGaAs, la zone de dérive d'une couche homogène AlGaAs ou d'une superstructure GaAs/AlGaAs, la zone de capture d'un puit quantique simple ou multiple GaAs/AlGaAs et la zone barrière à effet tunnel d'une couche homogène AlGaAs ou de couches individuelles AlGaAs et AlAs.

20. Détecteur de rayonnement à hétérostructure semiconductrice selon l'une des revendications 1 à 17,
**caractérisé en ce que** les systèmes de couches individuelles se composent de couches individuelles GaAs, AlGaAs et InGaAs pseudomorphiquement contraint, la zone d'excitation étant constituée d'une structure à puit quantique simple ou multiple GaAs/InGaAs/AlGaAs, la zone de dérive d'une couche GaAs homogène, la zone de capture d'un puit quantique simple ou multiple GaAs/InGaAs/AlGaAs et la zone barrière à effet tunnel d'une couche homogène AlGaAs ou de couches individuelles AlGaAs et AlAs.

21. Détecteur de rayonnement à hétérostructure semiconductrice selon l'une des revendications 1 à 17,
**caractérisé en ce que** les systèmes de couches individuelles se composent d'alliages InGaAs, InAlAs et/ou InAlGaAs quaternaires qui sont adaptés au réseau par rapport à la constante du réseau d'un substrat InP, et/ou de couches InP, la zone d'excitation étant constituée d'une structure à puit quantique simple ou multiple InGaAs, la zone de dérive d'une couche InAlGaAs ou InP homogène, la zone de capture d'une structure à puit quantique simple ou multiple InGaAs et la zone barrière à effet tunnel d'une couche homogène InAlAs, InP ou InAlGaAs ou de plusieurs couches individuelles de cette nature.

22. Détecteur de rayonnement à hétérostructure semiconductrice selon l'une des revendications 1 à 17,
**caractérisé en ce que** les systèmes de couches individuelles se composent de couches d'alliages SiGe, les variations de composition des alliages permettant d'obtenir la variation de la courbe de potentiel.

23. Détecteur de rayonnement à hétérostructure semiconductrice selon l'une des revendications 1 à 22,
**caractérisé en ce que** les systèmes de couches individuelles sont déposés de façon épitactique sur un wafer de substrat de sorte que les couches soient parallèles à la surface de couche, et **en ce que** des couches ayant subi un dopage de type n ou p sont prévues à des fins de contact électrique en dessus et en dessous des couches.

24. Détecteur de rayonnement à hétérostructure semiconductrice selon l'une des revendications 1 à 23,
**caractérisé en ce que** des couches barrières à effet tunnel sont prévues sur les bords de la couche active.
